# EUROPÄISCHE PATENTSCHRIFT

(11) **EP 1 973 740 B1**
(45) Veröffentlichungstag und Bekanntmachung des Hinweises auf die Patenterteilung: **07.04.2010**
(21) Anmeldenummer: 07703586.3
(22) Anmeldetag: 02.01.2007
(51) Int. Cl.: B41F 15/34, B41F 15/36, H05K 3/00, H05K 3/10, H05K 3/12, H05K 3/34, H05K 3/40

(54) **VERFAHREN ZUR HERSTELLUNG VON DRUCK-SCHABLONEN, INSBESONDERE FÜR RAKELDRUCKVERFAHREN**
METHOD FOR PRODUCING PRINTING MASKS, IN PARTICULAR FOR SQUEEGEE PRINTING
PROCEDE DE PRODUCTION DE POCHOIRS, EN PARTICULIER POUR DES PROCEDES D'IMPRESSION UTISLISANT UNE RACLE

(30) Priorität: 30.12.2005 DE 102005063282
(43) Veröffentlichungstag der Anmeldung: 01.10.2008
(73) Patentinhaber: Robert Bosch GmbH, 70442 Stuttgart (DE)
(72) Erfinder: MAIHOEFER, Bernd, 72760 Reutlingen (DE); MEIER, Andreas, 72793 Pfullingen (DE); LEVERKOEHNE, Mark, 588 41 Post Vyskytna Nad Jilavou (DE); SPEH, Ulrich, 71144 Steinenbronn (DE); LIEB, Gunther, 72135 Dettenhausen (DE); LEONHARD, Alexandra, 72793 Pfullingen (DE); SCHAEFER, Joerg, 71088 Holzgerlingen (DE)
(86) Internationale Anmeldenummer: PCT/EP2007/050010
(87) Internationale Veröffentlichungsnummer: WO 2007/077235

(56) Entgegenhaltungen:
- US-A1- 2002 145 203
- US-A1- 2003 111 518

## Beschreibung

### Stand der Technik

Die Erfindung geht aus von einem Verfahren zur Herstellung von Druck-Schablonen nach den Oberbegriffen der Ansprüche 1 und 4.

Integrierte elektronische Bauteile umfassen üblicherweise wenigstens eine Leiterplatte, auf deren Oberseite elektronische Leistungsbauelemente angeordnet sind. Es ist bekannt, insbesondere bei einem Leiterplatten-Material aus Kunststoff oder Keramik-Folien, Kontaktöffnungen bzw. Durchkontaktierungen in die Leiterplatten zu bohren bzw. zu stanzen, deren Durchmesser sich im µ-Bereich bewegen und als µ-Vias (bzw. Mikrovias) bezeichnet werden. Die Vias sind einerseits zur Unterstützung eines vertikalen Wärmetransports von den auf der Oberseite der Trägerplatte angeordneten elektronischen Leistungsbauelementen zur Unterseite vorgesehen. Derartige thermische Durchkontaktierungen (bzw. thermische vias) sind als kleine Löcher oder Sacklöcher ausgebildet, die mittels Lasertechnik oder mechanisch mit einem Mikrobohrer oder einer Stanznadel erzeugt und zur Wärmeleitung genutzt werden können. Andererseits können die Durchkontaktierungen zur elektrischen Verbindung von auf den auf der Oberseite der Leiterplatte angeordneten Bauelementen einer Schaltungsanordnung und einer dort aufgebrachten metallischen Leiterbahnstruktur zu deren Unterseite vorgesehen sein (so genannte elektrische vias). Im Schablonendruckprozess werden die zuvor erzeugten Vias mit einer leitfähigen Paste gefüllt.

Zur Durchführung dieses so-genannten "Via-Fill-Prozesses", insbesondere bei Keramikstrubstraten (bzw. Keramiktape), werden Schablonen eingesetzt, die beispielsweise in Lasertechnik hergestellt werden. Nachteilig dabei ist, dass sich Fertigungstoleranzen von beispielsweise gestanzten Vias im Keramiktape sowie Toleranzen, die während des Herstellungsprozesses dieser Via-Fill-Schablonen entstehen, kumulieren, was ungünstige Auswirkungen auf den Via-Fill-Prozess haben kann.

Die US 2002/145203 A1 beschreibt ein Verfahren zur Herstellung einer Druckschablone, bei der auf der Schablone eine Mustervorlage abgebildet wird, die einer Anordnung von Kontaktöffnungen auf der Leiterplatte korrespondiert. Die Öffnungen in der Schablone wird mittels Laser hergestellt.

### Vorteile der Erfindung

Bei einem Verfahren zur Herstellung von Druck-Schablonen, insbesondere solcher zur Verwendung beim Befüllen wenigstens einer in einer Leiterplatte ausgebildeten Kontaktöffnung, wird erfindungsgemäß eine auf der Schablone abgebildete Mustervorlage im gleichen Arbeitsprozess, vorzugsweise durch Cluster-Stanzen, hergestellt wie eine Kontaktöffnung auf der Leiterplatte. Dabei wird auf der Schablone eine Mustervorlage abgebildet, die mit einer Anordnung von Kontaktöffnungen auf der Leiterplatte korrespondiert. Besonders vorteilhaft dabei ist, dass Fertigungstoleranzen eliminiert werden können.

Bevorzugt kann die Schablone bzw. die Mustervorlage auf der Schablone mit demselben Werkzeug hergestellt werden wie die Kontaktöffnung. Besonders bevorzugt wird die Mustervorlage gestanzt, wobei der Stanzvorgang vorzugsweise mit einem Mehrfachwerkzeug (Clusterstanzwerkzeug) durchgeführt wird. Dadurch, dass die Schablone mit dem gleichen Clusterstanzwerkzeug hergestellt wird wie die Vias im Keramiktape, sind Schablone und Vias deckungsgleich ausgebildet, was sich vorteilhaft auf das Befüllen der Vias auswirkt.

Eine Schablonenvorrichtung mit einer Druck-Schablone, insbesondere zur Verwendung beim Befüllen wenigstens einer in einer Leiterplatte ausgebildeten Kontaktöffnung, ist im gleichen Arbeitsprozess wie die Kontaktöffnung herstellbar, insbesondere in einem Stanzvorgang. Bevorzugt werden die Öffnungen auf der Mustervorlage gestanzt, beispielsweise mit einem Clusterstanzwerkzeug. Nachteilige Fertigungstoleranzen können günstigerweise bei einer derartigen Schablone unterbunden werden. Die Schablone wird somit höchsten Ansprüchen an die Genauigkeit der Position und Größe der Vias gerecht.

### Zeichnungen

Weitere Ausführungsformen, Aspekte und Vorteile der Erfindung ergeben sich auch unabhängig von ihrer Zusammenfassung in Ansprüchen, ohne Beschränkung der Allgemeinheit aus nachfolgend anhand von Zeichnungen dargestellten Ausführungsbeispielen der Erfindung.

Im Folgenden zeigen schematisch
- Fig. 1a,b: einen erfindungsgemäßer Herstellungsprozess einer Schablone in einem Stanzwerkzeug vor dem Stanzvor- gang (Fig. 1 a) und nach dem Stanzvorgang (Fig. 1 b);
- Fig. 2: einen Befüllvorgang von Vias in einem Via-Fill-Prozess mittels einer Schablone, die nach dem Stand der Technik hergestellt ist; und
- Fig. 3: den Via-Fill-Prozess mittels einer Ausführungsform einer Schablone.

### Beschreibung des Ausführungsbeispiels

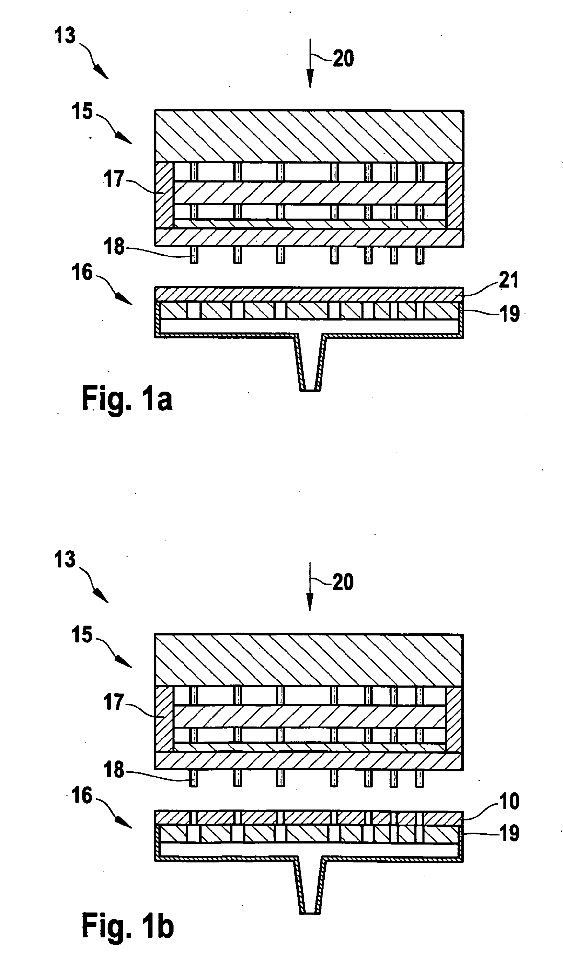

In der Fig. 1a und 1b ist schematisch ein erfindungsgemäßer Herstellungsprozess einer Schablone 10 mittels eines Stanzwerkzeugs 13 gezeigt. Das Stanzwerkzeug 13 umfasst ein Oberteil 15 und ein Unterteil 16. Das Oberteil 15 umfasst einen Stempel 17 sowie Stanznadeln 18, die in Stanzrichtung 20 hin- und herbewegt werden können und gemäß einem vorgegebenen Schnittmuster ein auf einer Schnittplatte 19 angeordnetes Element stanzt. In Fig. 1a ist zwischen dem Oberteil 15 und dem Unterteil 16 ein noch unbearbeiteter Schablonen-Rohling 21 eingespannt. In Fig. 1b ist der Schablonen-Rohling 21 gestanzt und als Schablone 10 beispielsweise bei einem Via-Fill-Prozess einsetzbar.

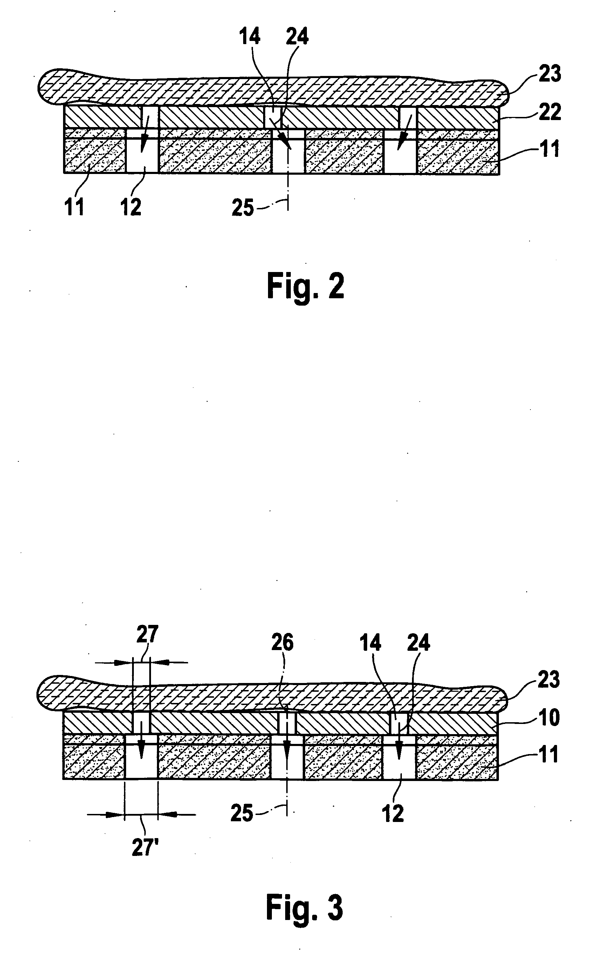

In Fig. 2 ist ein Befüllvorgang von Vias in einem Via-Fill-Prozess mittels einer Schablone 22 illustriert, die nach dem Stand der Technik hergestellt, beispielsweise gelasert ist. Die Leiterplatte 11 ist insbesondere aus einem Keramiksubstrat bzw. Keramiktape gebildet und weist Kontaktöffnungen 12 in Form von Sacklöchern bzw. Vias auf. Die Mustervorlage der gelaserten Schablone 22 entspricht nicht exakt der Anordnung der Vias 12 in der Leiterplatte 11, so dass sich die Öffnungen 14 in der Schablone 22 nicht mit den Vias 12 decken. Ein Befüllvorgang der Vias 12 mit einer Paste 23 wird durch diese Ungenauigkeit erschwert, beispielsweise weil eine Befüllrichtung 24 nicht entlang einer Via-Achse 25 erfolg, sondern schräg dazu. Dadurch besteht die Gefahr, dass die Vias 12 nach dem Befüllvorgang nicht vollständig mit der Paste 23 gefüllt sind, so dass elektrische und thermische Unterbrechungen entstehen können.

In Fig. 3 ist eine Schablone 10 dargestellt, wobei eine auf der Schablone 10 abgebildete Mustervorlage im gleichen Arbeitsprozess hergestellt ist wie eine Anordnung von Vias 12 auf einer leiterplatte 11. Insbesondere sind die Mustervorlage auf der Schablone 10 sowie die Vias 12 auf der Leiterplatte 11 mit demselben Werkzeug 13 hergestellt. Insbesondere sind sie mit einem Stanzwerkzeug hergestellt bzw. gestanzt. Die bei der Fertigung der Vias 12 und der Schablone 10 sich kumulierenden Toleranzen werden dadurch günstigerweise eliminiert, und ein Mittelpunkt 26 der Öffnungen 14 auf der Mustervorlage der Schablone 10 deckt sich jeweils mit der Zentralachse 25 der einzelnen Vias 12.

Das Material, aus welchem die Schablone 10 gefertigt ist, kann so ausgewählt sein, dass die auf der Mustervorlage gebildeten Öffnungen 14 einen kleineren Durchmesser 27 aufweisen als ein Durchmesser 27' der Vias 12. Die Schablone 10 kann vor dem Befüllen mit den Vias 12 in Deckung gebracht werden. Sobald die Schablone 10 richtig platziert ist, können die Vias 12 präzise mit der Paste 23 befüllt werden, wobei Unterfüllungen vermieden werden. Nach dem Befüllen der Vias 12 am Ende des Rakelvorgangs wird die Schablone 10 wieder abgehoben.

## Patentansprüche

1. Verfahren zur Herstellung von Druck-Schablonen (10), insbesondere für Rakeldruckverfahren, insbesondere solcher zur Verwendung beim Befüllen wenigstens einer in einer Leiterplatte (11) ausgebildeten Kontaktöffnung (12), wobei auf der Schablone (10) eine Mustervorlage abgebildet wird, die einer Anordnung von Kontaktöffnungen (12) auf der Leiterplatte korrespondiert, wobei die auf der Schablone (10) abgebildete Mustervorlage im gleichen Arbeitsprozess hergestellt wird wie die die wenigstens eine Kontaktöffnung (12) auf der Leiterplatte (11), **dadurch gekennzeichnet, dass** die Schablone (10) mit demselben Werkzeug (13) hergestellt wird wie die Kontaktöffnung (12).

2. Verfahren nach Anspruch 1, **dadurch gekennzeichnet, dass** die Schablone (10) gestanzt wird.

## Claims

1. Method for the production of printing screens (10), in particular for squeegee printing processes, in particular those for use in the filling of at least one contact port (12), formed in a circuit board (11), a pattern copy which corresponds to an arrangement of contact ports (12) on the circuit board being mapped on the screen (10), the pattern copy mapped on the screen (10) being produced in the same work process as the at least one contact port (12) on the circuit board (11), **characterized in that** the screen (10) is produced by means of the same tool (13) as the contact port (12).

2. Method according to Claim 1, **characterized in that** the screen (10) is stamped.

## Revendications

1. Procédé de fabrication de pochoirs d'impression (10), notamment pour des procédés d'impression à la racle, notamment pour l'utilisation lors du remplissage d'au moins une ouverture de contact (12) réalisée dans une carte de circuits imprimés (11), une ébauche de motif étant reproduite sur le pochoir (10), et correspondant à un agencement d'ouvertures de contact (12) sur la carte de circuits imprimés, l'ébauche de motif reproduite sur le pochoir (10) étant fabriquée dans le même processus de travail que l'au moins une ouverture de contact (12) sur la carte de circuits imprimés (11), **caractérisé en ce que** le pochoir (10) est fabriqué avec le même outil (13) que l'ouverture de contact (12).

2. Procédé selon la revendication 1, **caractérisé en ce que** le pochoir (10) est estampé.
